# EUROPEAN PATENT APPLICATION

(11) **EP 1 717 029 A2**
(43) Date of publication of application: **02.11.2006**
(21) Application number: 06113269.2
(22) Date of filing: 28.04.2006
(51) Int. Cl.: B41F 15/42, H05K 3/12

(54) **Screen printer**

(30) Priority: 28.04.2005 JP 2005130859
(71) Applicant: Minami Co. Ltd., Fuchu-shi, Tokyo (JP)
(72) Inventor: Murakami, Takehiko c/o Minami Co., Ltd, Tokyo (JP)
(74) Representative: Viering, Jentschura & Partner

(57) **Abstract**

An objective of the present invention is to provide a screen printer capable of printing the whole surface of a flexible printed board where electronic parts have been mounted. In the printer, one pair of paste coating devices 1, 12 is used. In the devices, portions of an elastic squeegee 7, a scraper 8, and the like which correspond to projection portions of a screen plate 11 respectively, are recessed in order to avoid contacting with the projection portions. A printing paste 2 is supplied onto the screen plate at a printing position, and the scraper 8 is scraped the printing paste on the screen plate 11 after finishing the printing, while keeping this state, the whole is moved upward together, and returned to the direction of an original position. These devices 1, 12 are provided at a suitable position of the flexible printed board so as to cross each other, and the flexible printed board is printed successively in the running direction or the direction rectangularly crossing with the running direction of the flexible printed board. The screen plate 11 has the projection portions 11A for covering electronic parts at positions corresponding the electronic parts mounted on the flexible printed board, and has pattern holes 11B, 11C, which are formed between each projection portion 11A and on both end sides in the width direction of the screen plate, at the outsides of the projection portions 11A.

## Description

### BACKGROUND OF THE INVENTION

### Field of the Invention

The present invention relates to a screen printer.

### Description of the Conventional Art

A conventional screen printer comprises a base stand on which an object to be printed is placed, a screen plate stretched on the base stand in parallel to the upper surface of the base stand, a means for supplying a paste onto the screen plate, and a squeegee for passing the paste throughpattern holes of the screen plate.

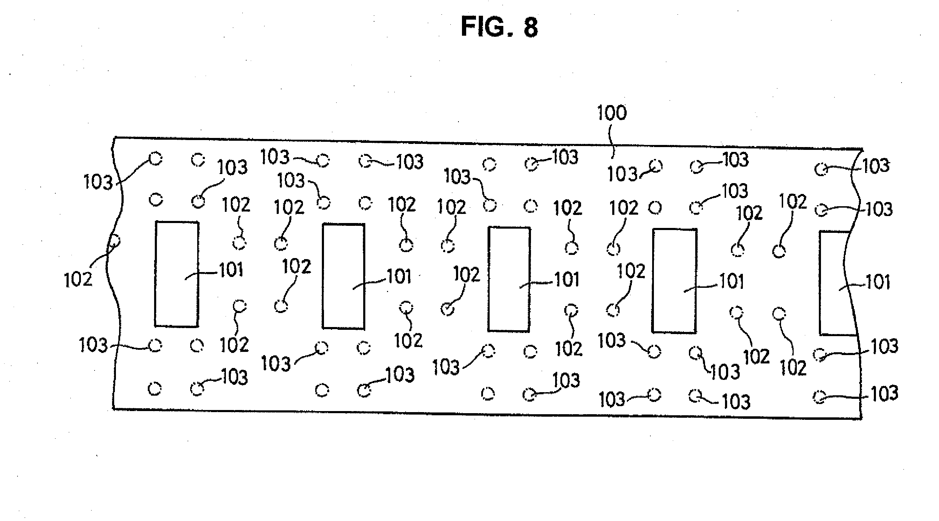

Further, as the object to be printed by a screen printing, there is a flexible printed board, which comprises a long film as illustrated with a code 100 in Figure 8. In case of the flexible printed board, identical patterns are printed at predetermined intervals along the longitudinal direction.

By the way, since an electronic device is reduced in size recently, a built-in electronic part in the device is also reduced in size, and the electronic parts are crowdedly provided within a narrow range. Therefore, it is desired that as many electronic parts as possible are mounted within the narrow range in the flexible printed board 100.

However, the conventional screen printer has a structure, in which the whole width of the squeegee is slid while contacting closely with the screen plate. Thus, as illustrated in the drawings, after electronic parts 101, 101, 101 ··· are mounted on the flexible printed board, the electronic parts become obstructive, so that re-printing cannot be carried out. That is, for example, as illustrated in Figure 8, prints 102, 102, 102 ··· between the electronic parts 101 cannot be carried out, and prints 103, 103, 103 ··· at left and right end portions in the width direction of the flexible printed board at the outside of each electronic part 101 cannot be carried out.

### Summary of the Invention

The present invention solves the above-described problems, and an objective of the present invention is to provide a screen printer capable of printing the whole surface of the flexible printed board where the electronic parts have been mounted.

In an aspect of the present invention, a screen printer has one pair of paste coating devices comprising a printing paste supply mechanism and a scraper for scraping a paste on a screen plate. The printing paste supply mechanism comprises a bag shaped container filled with a printing paste; a mechanism for housing the bag shaped container and pressing it; a printing paste supply plate provided with a printing paste supply port; and an elastic squeegee having a rear surface formed at a fixed angle corresponding to an angle at the time of printing and a front surface integrally formed with a hard thin board. The mechanism for pressing the bag shaped container is connected to the rear surface side of the printing paste supply plate, the rear surface of the squeegee is contacted with the printing paste supply port on the front surface side of the printing paste supply plate, the printing paste supply port can be opened/closed by vertically moving the squeegee, and thereby a predetermined amount of the printing paste can be supplied. Portions of the printing paste supply plate, the elastic squeegee and the scraper, which correspond to projection portions of the screen plate respectively, are recessed in order to avoid contacting with the projection portions, and the printing paste supply plate, the elastic squeegee and the scraper are integrally moved. One pair of the paste coating devices are provided at suitable positions in the running direction of the flexible printed board so as to cross each other. Then, the flexible printed board is printed successively in the running direction or the direction rectangularly crossing with the running direction. Further, projection portions for covering electronic parts are formed at positions on the screen plate, which correspond to the electronic parts mounted on the flexible printed board. Furthermore, pattern holes are formed between the projection portions and on the both end sides in the width direction of the screen plate at the outsides of the projection portions.

The present invention has the above-described structure, so that the whole surface of the flexible printed board, where the electronic parts have been mounted can be printed.

### BRIEF EXPLANATION OF DRAWINGS

Figure 1 is an explanation view of a structure of a paste coating device on one side in the present invention.
Figure 2 is an explanation view of positions of a screen plate and paste coating devices in the present invention.
Figure 3 is an explanation view of a printing operation of a paste coating device on one side.
Figure 4 is a cross-sectional view of a state of the paste coating device on one side at the time of printing.
Figure 5 is an explanation view of a printing operation of the paste coating device on another side.
Figure 6 is a cross-sectional view of a state of the paste coating device on another side at the time of printing.
Figure 7 is a plan view of a flexible printed board in a state at the time of completion of the printing by the present invention.
Figure 8 is a plan view of a flexible printed board where electronic parts are mounted.

### DETAILED DESCRIPTION OF PREFERRED EMBODIMENT

The preferred embodiment of the present invention is as follows. One pair of paste coating devices are used. In the devices, respective portions of the elastic squeegee, the scraper and the like, which correspond to the projection portions of the screen plate, are recessed in order to avoid contacting with the projection portions. The printing paste is supplied on the printing position of the screen plate, and when the elastic squeegee reaches to a printing terminal end, the scraper scraps off the printing paste on the screen plate. While keeping these states, the whole of the device integrally is moved upward, and is returned toward an original position of the screen plate. These paste coating devices are provided at the suitable position in the running direction of the flexible printed board so as to cross each other, and the flexible printed board is printed successively in the running direction or the direction rectangularly crossing with the running direction. Further, the projection portions for covering the electronic parts are formed at positions of the screen plate, which correspond to the electronic parts mounted on the flexible printed board. Furthermore, the pattern holes are formed between each projection portion and on the both end sides in the width direction of the screenplateat the outsides of the projection portions.

### [Example]

Hereinafter, examples of the present invention will be described.

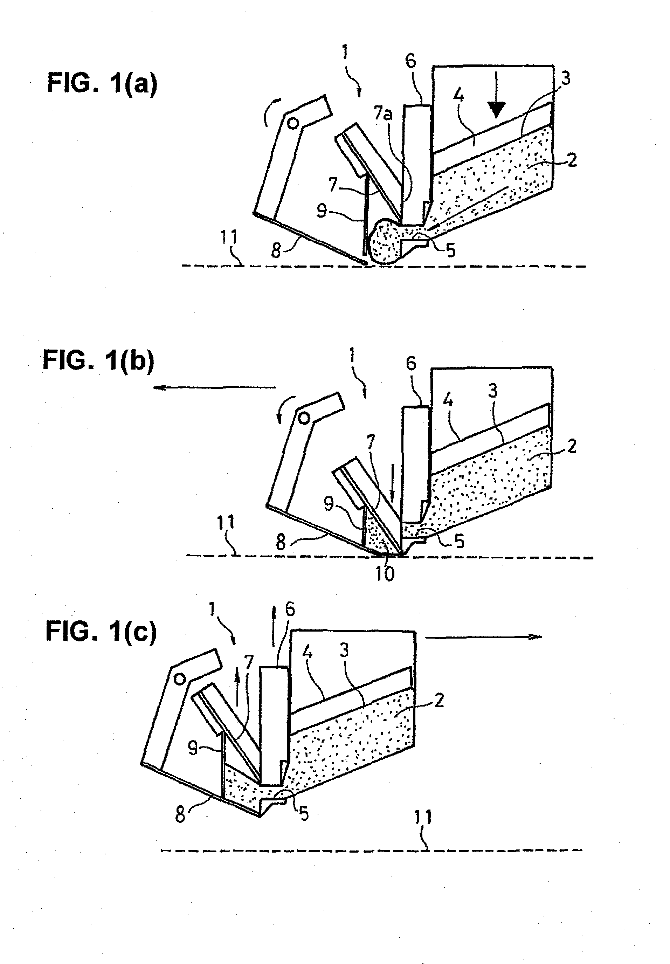

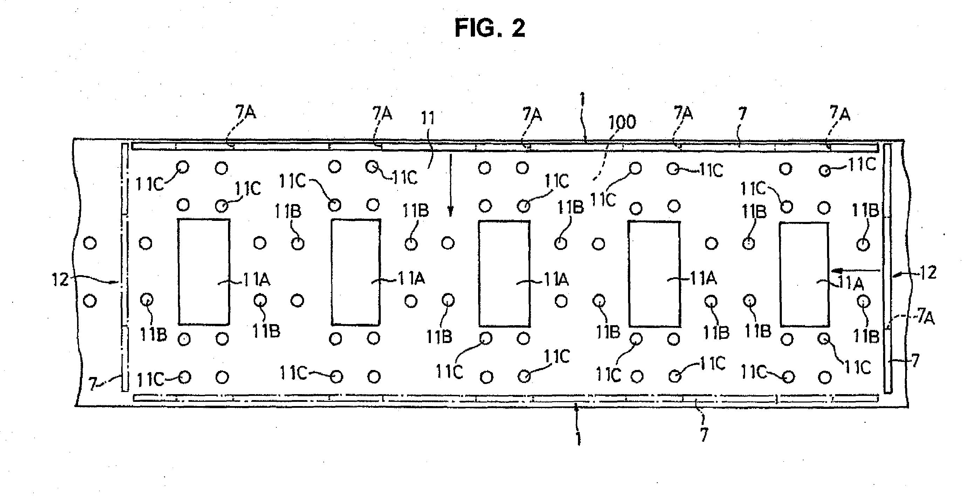

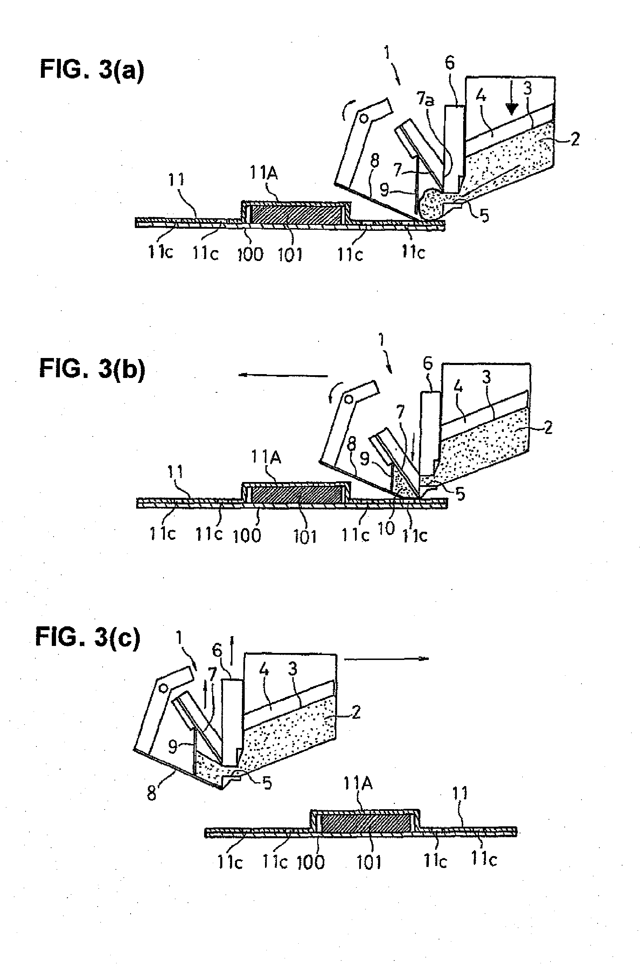

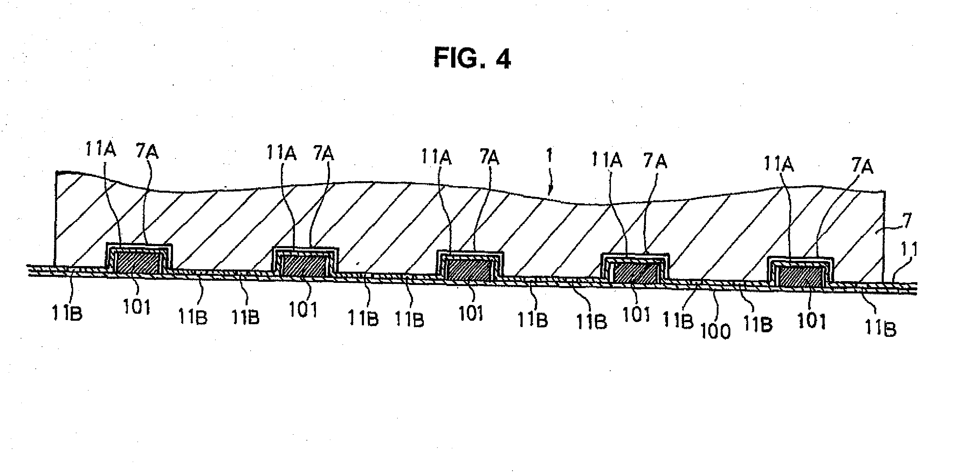

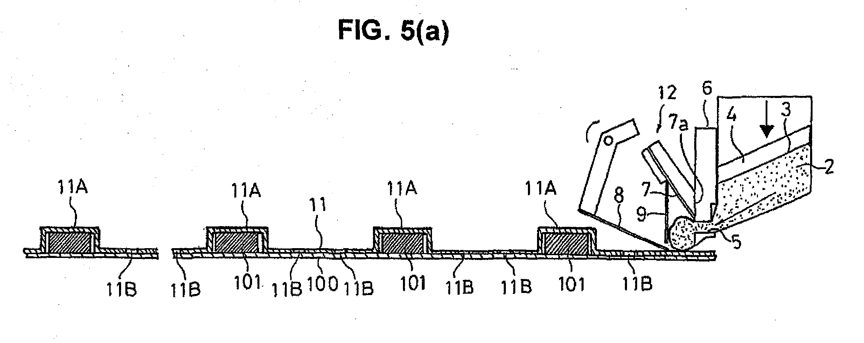

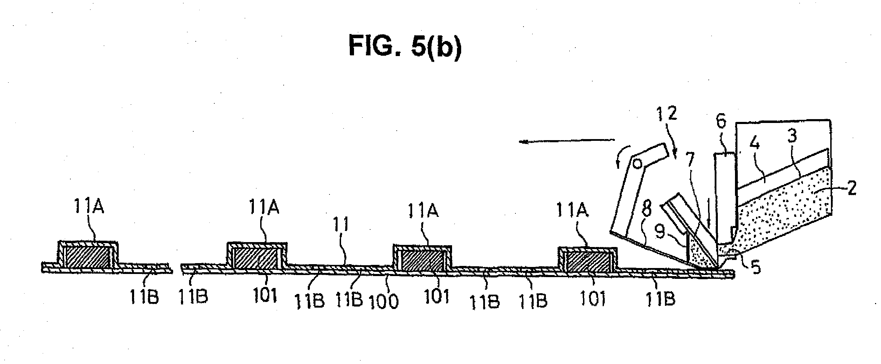

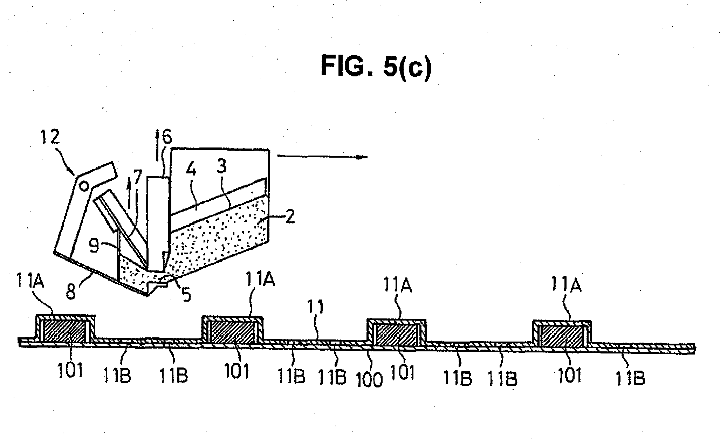

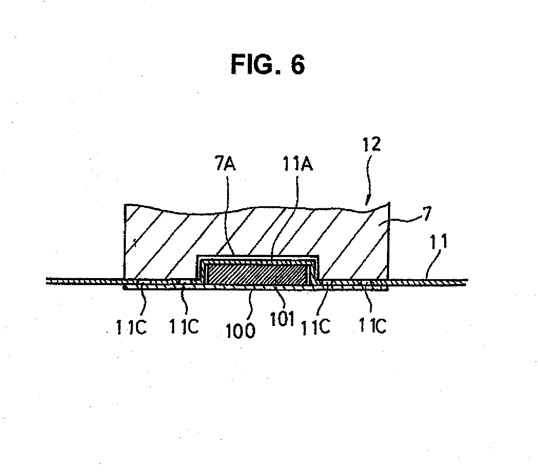

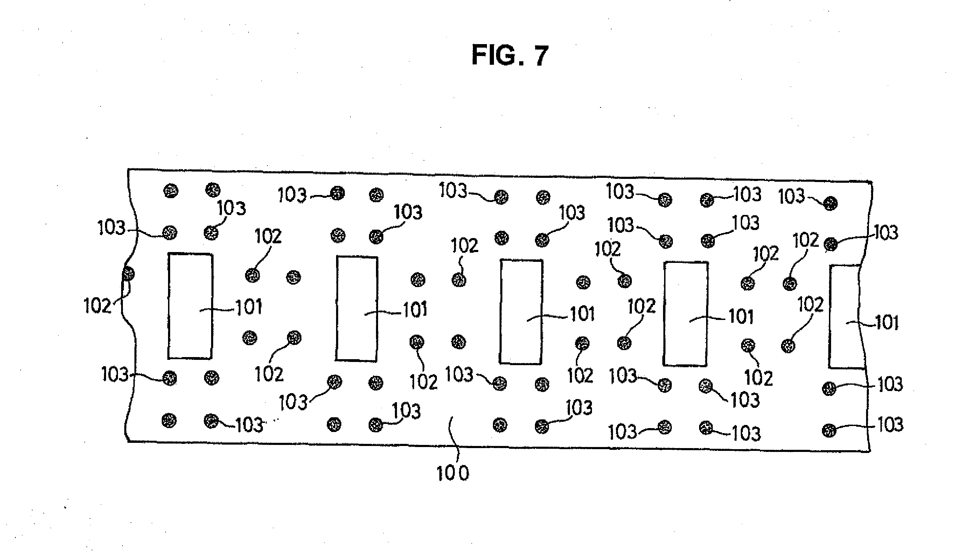

Figure 1 is an explanation view of a structure of a paste coating device on one side in the present invention. Figure 2 is an explanation view of positions of a screen plate and paste coating devices in the present invention. Figure 3 is an explanation view of a printing operation of a paste coating device on one side. Figure 4 is a cross-sectional view of a state of the paste coating device on one side at the time of printing. Figure 5 is an explanation view of a printing operation of the paste coating device on another side. Figure 6 is a cross-sectional view of a state of the paste coating device on another side at the time of printing. Figure 7 is a plan view of a flexible printed board in a state at the time of completion of the printing by the present invention.

In the drawings, Code 1 is one of one pair of paste coating devices, and for carrying out the prints 102, 102, 102··· in a flexible printed board 100 illustrated in Figure 8. Further, the paste coating device 1 basically has the same structure as that of the screen printer indicated in Japanese Patent Application Laid Open No. 2002-234133. The structure comprises a printing paste supply mechanism and a scraper 8 for scraping a paste on a screen plate. The printing paste supply mechanism comprises a bag shaped container 3 filled with a printing paste 2; a mechanism 4 for housing the bag shaped container 3 and pressing it; a printing paste supply plate 6 provided with a printing paste supply port 5; and an elastic squeegee 7 in which a rear surface 7a is formed having a fixed angle corresponding to an angle at the time of printing and a front surface is integrally formed with a hard thin board. In the printing paste supply mechanism, the mechanism 4 for pressing the bag shaped container 3 is connected to the rear surface side of the printing paste supply plate 6; the rear surface of the squeegee 7 is contacted with the printing paste supply port 5 on the front surface side of the printing paste supply plate 6; the printing paste supply port 5 can be opened/closed by vertically moving the squeegee 7; and thereby a predetermined amount of the printing paste 2 can be supplied. Code 9 is an elastic separating portion, and code 10 is a printing paste storing part. Code 11 is a screen plate.

Then, an operation of the printer will be described.

At the time of printing, as illustrated in Figure 1 (a), the squeegee 7 is positioned at the upper part of the printing paste supply port 5 by sliding it along the wall surface on the front surface side of the printing paste supply plate 6, and the printing paste supply port 5 is opened. Then, the printing paste 2 is pressed by the printing paste pressing device 4, and the predetermined amount of it is pushed out from the printing paste supply port 5. Then, as illustrated in Figure 1 (b), the squeegee 7 is moved downward by sliding it along the wall surface of the printing paste supply plate 6, and the printing paste supply port 5 is closed. Then, the printing paste storing part 10 is made at a space surrounded with the scraper 8, the elastic separating portion 9, the squeegee 7 and the screen plate 11, and the printing paste 2 is enclosed in the printing paste storing part 10. Then, while keeping this state, the printing paste 2 is moved on the screen plate 11, and the pattern is printed on the object to be printed (it is not illustrated in the drawirigs).

As illustrated in Figure 1 (c), when the printing operation is completed, the scraper 8 is rotated toward the squeegee 7 while sliding it on the screen plate 11, to thereby scrape the paste 2 remaining on the screen plate 11. Then, the squeegee7, the printing paste 2, the printing paste supply plate 6, the printing paste pressing device 4, the scraper 8 and the elastic separating portion 9, which are integrated, are moved upward, and returned to a print starting direction.

Further, as for the paste coating device 1 according to this example, in the above-described structure, the portions of the printing paste supply plate 6, the elastic squeegee 7, the scraper 8 and the elastic separating portion 9, which correspond to the projection portions of the screen plate described below, are recessed respectively in order to avoid contacting with the projection portions. In addition, the elastic squeegee 7 having the above-described structure is illustrated in Figure 4, and code 7A is a recessed portion. Further, parts other than the elastic squeegee 7 also have the same structure as that of the squeegee 7. On the other hand, on the screen plate 11, projection portions 11A, 11A, 11A··· for covering the electronic parts are formed at positions corresponding to the electronic parts mounted on the flexible printed board. Further, on the screen plate 11, pattern holes 11B, 11B, 11B··· and 11C, 11C, 11C··· are formed at positions for carrying out the prints between the electronic parts and the outsides of the electronic parts in the flexible printed board, that is, for carrying out the prints 102, 102, 102··· and 103, 103, 103··· in Figure 8.

Code 12 is another of one pair of paste coating devices, and for carrying out the prints 103, 103, 103··· in the flexible printed board 100 illustrated in Figure 8. Further, as for the structure of this another device, it is same as that of the one device except positions of recessed portions provided at the printing paste supply plate, the elastic squeegee, the scraper and the elastic separating portion are different respectively. Thus, same codes are used to same members, and detailed descriptions are omitted.

Further, as illustrated in Figure 2, one pair of the paste coating devices 1, 12 is provided at the suitable position in the running direction of the flexible printed board so as to cross each other. That is, the one paste coating device 1 is provided so as to print in the direction rectangularly crossing with the running direction of the flexible printed board, and the another paste coating device 12 is provided so as to print in the running direction of the flexible printed board. Further, as for these paste coating devices 1, 12, after the printing by the one paste coating device 1 is completed, the printing by the another paste coating device 12 is carried out.

Then, printing operations of the above-described paste coating devices 1, 12 will be described.

First, the operation of the one paste coating device 1 will be described. As illustrated in Figure 3 (a), at the time of printing, the printing paste 2 is pushed out on the screen plate 11 at the print starting position (a position illustrated with a solid line in Figure 2). Then, as illustrated in Figure 3 (b), the printing paste storing part 10 is made with the space surrounded with the scraper 8, the elastic separating portion 9, the squeegee 7 and the screen plate 11, and the printing paste 2 is enclosed in this part 10. While keeping this state, the printing paste 2 is moved in the direction rectangularly crossing with the running direction of the flexible printed board, that is, in the width direction of the screen plate 11, and thereby the printing is carried out. When the printing is completed, the scraper 8 is rotated toward the squeegee 7 while sliding it on the screen plate 11 as illustrated in Figure 3 (c), to thereby scrape the paste remaining on the screen plate 11. Then, the squeegee7, the printing paste 2, the printing paste supply plate 6, the printing paste pressing device 4, the scraper 8 and the elastic separating portion 9, which are integrated, are moved upward, and stays at a stand-by position in which the printing by the another paste coating device 12 is not prevented (a position illustrated with a virtual line in Figure 2).

Further, as for the another paste coating device 12, the operation is the same as that of the one paste coating device 1 as illustrated in Figures 5 (a), (b) and (c), so that the detailed description is omitted. However, the printing by the another paste coating device 12 is completed, while the one paste coating device 1 stays at the stand-by position illustrated with the virtual line in Figure 2 after completion of the printing, and the device 12 is moved upward and returned to the print starting position which is illustrated with a solid line. Then, the one paste coating device 1 is returned to the print starting position. Thus, when the both printings by the paste coating devices 1, 12 are completed, the whole surface of the flexible printed board 100 mounted with the electronic parts 101 can be printed as illustrated in Figure 7. In addition, Codes 102 and 103 indicate printed parts respectively.

## Claims

1. A screen printer, having one pair of paste coating devices comprising a printing paste supply mechanism and a scraper for scrapping a paste on a screen plate, in which the printing paste supply mechanism comprises a bag shaped container filled with a printing paste; a mechanism for housing the bag shaped container and pressing it; a printing paste supply plate provided with a printing paste supply port; and an elastic squeegee having a rear surface formed at a fixed angle corresponding to an angle at the time of printing and a front surface integrally formed with a hard thin board, the mechanism for pressing the bag shaped container is connected to the rear surface side of the printing paste supply plate, the rear surface of the squeegee is contacted with the printing paste supply port on the front surface side of the printing paste supply plate, the printing paste supply port can be opened/closed by vertically moving the squeegee, and thereby a predetermined amount of the printing paste can be supplied,
wherein positions of the printing paste supply plate, the elastic squeegee and the scraper, which correspond to projection portions of the screen plate respectively, are recessed in order to avoid contacting with the projection portions, and the printing paste supply plate, the elastic squeegee and the scraper are integrally moved,
wherein one pair of the paste coating devices are provided at suitable positions in the running direction of the flexible printed board so as to cross each other,
wherein the flexible printed board is printed successively in the running direction or the direction rectangularly crossing with the running direction,
wherein projection portions for covering electronic parts are formed at positions on the screen plate, which correspond to the electronic parts mounted on the flexible printed board, and
wherein pattern holes are formed between projection portions and on the both end sides in the width direction of the screen plate at the outsides of the projection portions.
